(19) Europäisches Patentamt
European Patent Office
Office européen des brevets

(11) **EP 4 647 786 A1**

(12) **EUROPEAN PATENT APPLICATION**

(43) Date of publication:
**12.11.2025 Bulletin 2025/46**

(21) Application number: **25172222.9**

(22) Date of filing: **24.04.2025**

(51) International Patent Classification (IPC):
***G01R 31/367*** (2019.01)   ***G01R 31/3842*** (2019.01)
***G01R 31/389*** (2019.01)   ***G01R 31/392*** (2019.01)

(52) Cooperative Patent Classification (CPC):
**G01R 31/389; G01R 31/367; G01R 31/3842;
G01R 31/392; B60L 58/16**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **06.05.2024 US 202418655605**

(71) Applicant: **STMicroelectronics International N.V.
1228 Plan-les-Ouates, Geneva (CH)**

(72) Inventors:
• **BONACCORSO, Filippo**
  **95013 Fiumefreddo di Sicilia (IT)**
• **BRANCIFORTE, Marco Maria**
  **95128 Catania (IT)**
• **CANNAVACCIUOLO, Salvatore**
  **80010 Villaricca (IT)**
• **D'ANGELO, Vittorio**
  **84015 Nocera Superiore (IT)**

(74) Representative: **Cabinet Beaumont
4, Place Robert Schuman
B.P. 1529
38025 Grenoble Cedex 1 (FR)**

(54) **ELECTROCHEMICAL IMPEDANCE SPECTROSCOPY PHASE AND AMPLITUDE DETECTION OF A STIMULATED SYSTEM**

(57)    Systems, apparatuses, and methods for electrochemical impedance spectroscopy (EIS) for use with batteries, including for EIS phase and amplitude detection of a stimulated system are provided. A battery management system comprising EIS circuitry (510) is electrically coupled to a battery (100). The EIS circuitry (510) provides a stimulus signal (512) to the battery to generate a response signal (514) from the battery (100). A current signal and voltage signal are generated by the EIS circuitry (510) based on the response signal (514) from the battery (100). The EIS circuitry (510) generates at least one output signal (522) based on the current signal and the voltage signal, and an impedance is generated based on the at least one output signal (522).

FIG. 5

**Description**

TECHNOLOGICAL FIELD

Example embodiments of the present disclosure relate generally to systems, apparatuses, and methods for electrochemical impedance spectroscopy (EIS) for use with batteries, and particularly for EIS phase and amplitude detection of a stimulated system.

BACKGROUND

Batteries are increasingly being used in a myriad of applications. Electrochemical impedance spectroscopy (EIS) may be used to generate information for determining a state of health of batteries. The state of health of a battery may indicate if a battery is healthy or aged, which may be used to prevent battery damage or determine when a battery should no longer be used.

The inventors have identified numerous areas of improvement in the existing technologies and processes, which are the subjects of embodiments described herein. Through applied effort, ingenuity, and innovation, many deficiencies, challenges, and problems have been solved by developing solutions that are included in embodiments of the present disclosure, some examples of which are described in detail herein.

BRIEF SUMMARY

Various embodiments described herein relate to systems, apparatuses, and methods for electrochemical impedance spectroscopy (EIS) for use with batteries, and particularly for EIS phase and amplitude detection of a stimulated system.

In accordance with some embodiments of the present disclosure, an example system is provided. The system may comprise: a battery; a battery management system comprising EIS circuitry, wherein the battery management system is electrically coupled to the battery; wherein the EIS circuitry comprising excitation circuitry configured to generate a stimulus signal; wherein the EIS circuitry is configured to provide the stimulus signal to the battery and to receive a response signal from the battery based on the stimulus signal; wherein the EIS circuitry further comprises a current sensing circuitry configured to generate a current signal based on the response signal; wherein the EIS circuitry further comprises a voltage sensing circuitry configured to generate a voltage signal based on the stimulus signal and the response signal; wherein the EIS circuitry further comprises a phase circuitry configured to generate a phase signal based on the current signal and the voltage signal; wherein the EIS circuitry further comprises a current amplitude circuitry configured to generate a current amplitude signal based on the current signal; wherein the EIS circuitry further comprises a voltage amplitude circuitry configured to generate a voltage amplitude signal based on the current signal; wherein an EIS processor is configured to generate at least one output signal based on the phase signal, the current amplitude signal, and the voltage amplitude signal; and wherein the battery management system is configured to generate a first impedance based on an EIS model and the at least one output signal.

In some embodiments, the voltage amplitude circuitry comprises a voltage peak-detector and the current amplitude circuitry comprises a current peak-detector.

In some embodiments, the phase circuitry comprises one of a phase shift detector, a phase detector, or a lock-in amplifier.

In some embodiments, the voltage amplitude circuitry comprises a voltage lock-in amplifier and the current amplitude circuitry comprises a current lock-in amplifier.

In some embodiments, the phase circuitry comprises one of a phase shift detector, a phase detector, or a lock-in amplifier.

In some embodiments, the at least one output signal comprises a first output signal of an output phase and a second output signal of an output amplitude.

In some embodiments, to generate a first impedance based on an EIS model and the at least one output signal the battery management system is configured to determine the first impedance from a look-up table.

In accordance with some embodiments of the present disclosure, an example battery management integrated circuit is provided. The battery management integrated circuit may comprise: a battery management processor; a EIS circuitry comprising excitation circuitry configured to generate a stimulus signal; wherein the EIS circuitry is configured to provide the stimulus signal to a battery and to receive a response signal from the battery based on the stimulus signal; wherein the EIS circuitry further comprises a current sensing circuitry configured to generate a current signal based on the response signal; wherein the EIS circuitry further comprises a voltage sensing circuitry configured to generate a voltage signal based on the stimulus signal and the response signal; wherein the EIS circuitry further comprises a phase circuitry configured to generate a phase signal based on the current signal and the voltage signal; wherein the EIS circuitry further comprises a current amplitude circuitry configured to generate a current amplitude signal based on the current signal; wherein the EIS circuitry further comprises a voltage amplitude circuitry configured to generate a voltage amplitude signal based on the current signal; wherein an EIS processor is configured to generate at least one output signal based on the phase signal, the current amplitude signal, and the voltage amplitude signal; and wherein the battery management processor is configured to generate a first impedance based on an EIS model and the at least one output signal.

In some embodiments, the voltage amplitude circuitry comprises a voltage peak-detector and the current amplitude circuitry comprises a current peak-detector.

In some embodiments, the phase circuitry comprises one of a phase shift detector, a phase detector, or a lock-in amplifier.

In some embodiments, the voltage amplitude circuitry comprises a voltage lock-in amplifier and the current amplitude circuitry comprises a current lock-in amplifier.

In some embodiments, the phase circuitry comprises one of a phase shift detector, a phase detector, or a lock-in amplifier.

In some embodiments, the at least one output signal comprises a first output signal of an output phase and a second output signal of an output amplitude.

In some embodiments, to generate a first impedance based on an EIS model and the at least one output signal the battery management processor is configured to determine the first impedance from a look-up table.

In accordance with some embodiments of the present disclosure, an example method is provided. The method may comprise: generating, with an excitation circuitry, a stimulus signal; transmitting the stimulus signal to a battery to generate a response signal; receiving the response signal at a EIS circuitry; generating, with the EIS circuitry, a current signal based on the response signal; generating, with the EIS circuitry, a voltage signal based on the response signal and the stimulus signal; generating, with a phase circuitry, a phase signal based on the current signal and the voltage signal; generating, with a current amplitude circuitry, a current amplitude signal; generating, with a voltage amplitude circuitry, a voltage amplitude signal; generating at least one output signal based on the phase signal, the current amplitude signal, and the voltage amplitude signal; and determining a first impedance based on an EIS model and the at least one output signal.

In some embodiments, the voltage amplitude circuitry comprises a voltage peak-detector and the current amplitude circuitry comprises a current peak-detector.

In some embodiments, the phase circuitry comprises one of a phase shift detector, a phase detector, or a lock-in amplifier.

In some embodiments, the voltage amplitude circuitry comprises a voltage lock-in amplifier and the current amplitude circuitry comprises a current lock-in amplifier.

In some embodiments, the phase circuitry comprises one of a phase shift detector, a phase detector, or a lock-in amplifier.

In some embodiments, the at least one output signal comprises a first output signal of an output phase and a second output signal of an output amplitude.

The above summary is provided merely for purposes of summarizing some example embodiments to provide a basic understanding of some aspects of the disclosure. Accordingly, it will be appreciated that the above-described embodiments are merely examples and should not be construed to narrow the scope or spirit of the disclosure in any way. It will also be appreciated that the scope of the disclosure encompasses many potential embodiments in addition to those here summarized, some of which will be further described below.

BRIEF SUMMARY OF THE DRAWINGS

Having thus described certain example embodiments of the present disclosure in general terms, reference will now be made to the accompanying drawings, which are not necessarily drawn to scale, and wherein:

FIG. 1 illustrates an example battery and equivalent impedance measurement circuit in accordance with one or more embodiments of the present disclosure;

FIG. 2 illustrates an exemplary EIS circuitry in accordance with one or more embodiments of the present disclosure;

FIG. 3 illustrates an exemplary battery impedance equivalent circuitry and associated impedance measurements, known also as Nyquist plot, in accordance with one or more embodiments of the present disclosure;

FIG. 4 illustrates an exemplary graph of impedance measurements in accordance with one or more embodiments of the present disclosure;

FIG. 5 illustrates a first exemplary block diagram for generating EIS measurements in accordance with one or more embodiments of the present disclosure;

FIG. 6 illustrates a first exemplary embodiment of phase and amplitude detector circuitry in accordance with one or more embodiments of the present disclosure;

FIG. 7 illustrates a second exemplary embodiment of phase and amplitude detector circuitry in accordance with one or more embodiments of the present disclosure;

FIG. 8 illustrates a third exemplary embodiment of phase and amplitude detector circuitry in accordance with one or more embodiments of the present disclosure;

FIG. 9 illustrates a fourth exemplary embodiment of phase and amplitude detector circuitry in accordance with one or more embodiments of the present disclosure;

FIG. 10 illustrates a fifth exemplary embodiment of phase and amplitude detector circuitry in accordance with one or more embodiments of the present disclosure;

FIG. 11 illustrates an exemplary lock-in amplifier circuitry in accordance with one or more embodiments of the present disclosure;

FIG. 12 illustrates second exemplary block diagram for generating EIS measurements in accordance with one or more embodiments of the present disclosure;

FIG. 13 illustrates an exemplary graph of filtered output signals in accordance with one or more embodiments of the present disclosure;

FIG. 14 illustrates an exemplary flowchart of a first set of operations for determining an impedance in accordance with one or more embodiments of the present disclosure;

FIG. 15 illustrates an exemplary flowchart of a second set of operations for determining an impedance in accordance with one or more embodiments of the present disclosure;

FIG. 16 illustrates an exemplary device in accordance with one or more embodiments of the present disclosure;

FIG. 17 illustrates an exemplary phase sensitive detector circuitry in accordance with one or more embodiments of the present disclosure;

FIG. 18 illustrates an exemplary peak-detector circuitry in accordance with one or more embodiments of the present disclosure;

FIG. 19 illustrates an exemplary phase detector circuitry in accordance with one or more embodiments of the present disclosure.

DETAILED DESCRIPTION

Some embodiments of the present disclosure will now be described more fully herein with reference to the accompanying drawings, in which some, but not all, embodiments of the disclosure are shown. Indeed, various embodiments of the disclosure may be embodied in many different forms and should not be construed as limited to the embodiments set forth herein; rather, these embodiments are provided so that this disclosure will satisfy applicable legal requirements. Like reference numerals refer to like elements throughout.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in various embodiments," "in one embodiment," "according to one embodiment," "in some embodiments," and the like generally mean that the particular feature, structure, or characteristic following the phrase may be included in at least one embodiment of the present disclosure and may be included in more than one embodiment of the present disclosure (importantly, such phrases do not necessarily refer to the same embodiment).

The word "example" or "exemplary" is used herein to mean "serving as an example, instance, or illustration." Any implementation described herein as "exemplary" is not necessarily to be construed as preferred or advantageous over other implementations.

If the specification states a component or feature "may," "can," "could," "should," "would," "preferably," "possibly," "typically," "optionally," "for example," "often," or "might" (or other such language) be included or have a characteristic, that a specific component or feature is not required to be included or to have the characteristic. Such a component or feature may be optionally included in some embodiments or it may be excluded.

The use of the term "circuitry" as used herein with respect to components of a system or an apparatus should be understood to include particular hardware configured to perform the functions associated with the particular circuitry as described herein. The term "circuitry" should be understood broadly to include hardware and, in some embodiments, software for configuring the hardware. For example, in some embodiments, "circuitry" may include processing circuitry, communications circuitry, input/output circuitry, and the like. In some embodiments, other elements may provide or supplement the functionality of particular circuitry.

Overview

Various embodiments of the present disclosure are directed to improved systems, apparatuses, and methods for electrochemical impedance spectroscopy (EIS) for use with batteries, and particularly for EIS phase and amplitude detection of a stimulated system. In various embodiments, a stimulated system may be a battery that is stimulated with a stimulus signal generated for detecting a phase and amplitude of an impedance using EIS.

Batteries are included in a myriad of applications. Exemplary applications include but are not limited to power tools, automotive, and consumer electronics. A battery in these applications may refer to an individual battery cell or a battery pack that includes multiple battery cells. Embodiments of the present disclosure may use the phrase battery to refer to either a battery cell or multiple battery cells.

Management of a battery may be with a battery management system. In various applications a battery management system may be referred to as a battery management subsystem. The battery management system may, among other things, determine a state of health of the battery. The state of health of a battery worsens with usage and age through repeated charge/discharge cycles. Determining a battery's state of health may indicate if a battery is healthy, aged, or how much longer a battery may have until it needs to be replaced. Such indications may assist in preventing battery damage, explosions, and/or advising when it is time for a new battery.

For example, an electric vehicle may use multiple battery packs. Each battery pack may include multiple battery cells. The battery cells collectively provide power storage for the electric vehicle. A battery management system of the electric vehicle may be used to monitor the health of the batteries using EIS, such as described herein.

A manner of determining the state of health of a battery is with electrochemical impedance spectroscopy (EIS). EIS evaluates a battery chemistry of a battery focusing on the equivalent circuit model. In this equivalent circuit model the battery may be modeled as a voltage source and an impedance.

An impedance is made of real component and an imaginary component. As a battery ages or is damaged the impedance changes. These changes may be demonstrated by graphing how the real component and imaginary component of the impedance change over time. The impedance may vary with frequency, which may also be graphed. EIS systems may determine an impedance at various frequencies, such as with frequency sweeps or by utilizing stimulus signals at various frequencies.

EIS applies a stimulus signal to a battery and measures a voltage and a current associated with a response of the battery to the stimulus signal, which is described as a response signal. EIS circuitry may include or be used with voltage sensors, current sensors, and/or phase sensors. By detecting the voltage, current, and phase, embodiments of the present disclosure may generate a state of health of a battery.

In addition to a state of health, EIS of a response signal may be utilized to estimate battery's state of charge as well as internal temperature, which may be used to prevent such events as thermal runaway. EIS may measure temperature indirectly, including without a temperature sensor or in addition to a temperature sensor. Further, in various embodiments a temperature sensor may be located outside a battery cell and measure a temperature at its location while EIS is used to determine a temperature of the battery based on, among other things the battery chemistry internal to the battery.

In various embodiments, a system or device may include a battery management system. EIS circuitry may be included the in the battery management system or may be provided in conjunction with the battery management system. The battery management system may receive an impedance value from the EIS circuitry, which may be provided as a single value or as an amplitude value and a phase value. Each of these values may be provided as a signal generated by the EIS system that is associated with the value, for example in an associated voltage value or current value that is associated with a value (e.g., a 3-volt signal may be associated with a maximum voltage of the battery). The battery management system may receive these signals and generate, based on these signals, one or more warning signals or status signals. One or more additional portions of the system or device may receive these signals transmitted from the battery management system and perform one or more operations based on these signals, such as display a warning, transmit a warning, cease battery operations, etc.

Batteries, especially in higher power applications, utilize battery management systems to analyze and evaluate the batteries. This may include determining a state of health of the battery. Conventional systems may utilize digital processing of sampled data, such as with Fast Fourier Transforms, machine learning, artificial intelligence, and the like. Further, conventional systems implementing EIS took respectively larger amounts of time to process due to, at least in part, frequency of conventional stimulus signals. Such conventional stimulus signals may range from mHz to kHz and, thus, signals with longer time periods took longer to sample and digitally process. Such conventional systems require large memory and computational resources to process such sampled data. Embodiments of the present disclosure provide many improvements over such conventional systems. Embodiments of the present disclosure include an approach for determining phase and amplitude for use in EIS, which allows for lower memory requirements and lower computational resources. One example of lower computational requirements is with embodiments configured using analog circuitry to lower what may otherwise be performed with digital computation. Various embodiments of the present disclosure synchronously acquire voltage and current associated with a battery's response signal with analog circuitry, which increases the speed of EIS analysis. Additionally, such analog circuitry may lower the physical space or footprint required to implement the embodiments, which may also reduce cost. Additionally or alternatively, embodiments of the present disclosure include improvements of reduced harmonic content of measured signals.

Exemplary Systems, Apparatuses, and Methods

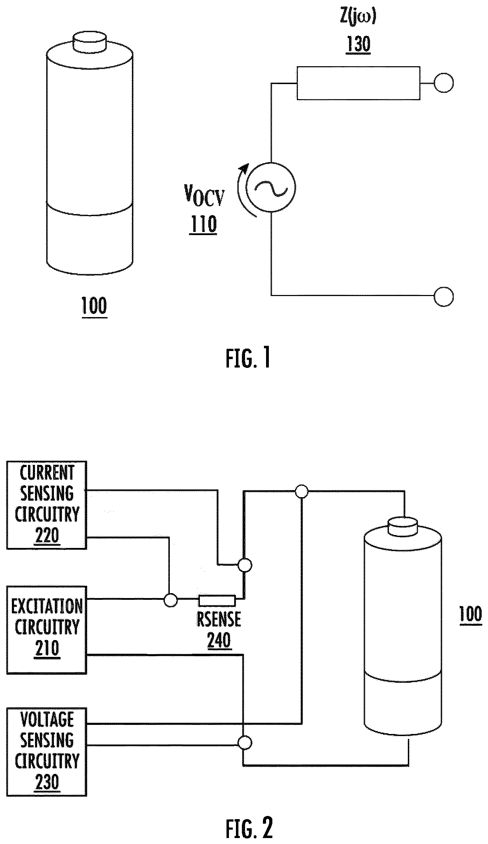

FIG. 1 illustrates an example battery and equivalent circuit in accordance with one or more embodiments of the present disclosure. A battery 100 has a battery chemistry that is associated with an equivalent circuit comprised of a voltage source 110, a current 120, and an impedance 130. The impedance 130 may be measured based on the voltage of voltage source 110 and current.

EIS measurements may be performed during both charging and discharging of a battery. A voltage measurement may be V(t) of the equivalent voltage source 110, which is illustrated as an open circuit voltage Vocv. A current measurement may be I(t) of the equivalent current through an impedance 130 $Z(j\omega)$. Measurements of the voltage V(t) and current I(t) may be used to evaluate the impedance 130 $Z(j\omega)$ of the battery 100.

While battery 100 is illustrated as a single battery, a battery 100 may include multiple battery cells. An impedance 130 may be measured at each battery cell, all battery cells collectively, or as one or more groupings of multiple battery cells.

FIG. 2 illustrates an exemplary EIS circuitry in accordance with one or more embodiments of the present disclosure. The EIS circuitry may comprise, among other things, an excitation circuitry 210, a current sensing circuitry 220, a voltage sensing circuitry 230, and a sensing resistor 240. The EIS circuitry may be electrically connected to at least one battery 100.

The EIS circuitry includes multiple analog circuitry and/or circuitry components to minimize the digital computation required. In various embodiments, the EIS circuitry also includes an EIS processor in addition to the analog circuits. The EIS processor (e.g., a MCU) may interface with a battery management system (BMS).

The EIS circuitry measures current and voltage of a response of the battery to a stimulus signal. The stimulus signal is generated by an excitation circuitry 210.

The excitation circuitry 210 generates the stimulus signal and provides it to the battery 100 and a response signal is measured for both current and voltage. The voltage and current measurements may be synchronously acquired for use in generating one or more signals for generating an impedance 130. The current is measured across a sensing resistor 240, which is illustrated as RSENSE 240. The current is measured with current sensing circuitry 220 to generate a current signal. The voltage is measured based on the stimulus signal and the response signal. The voltage is measured with voltage sensing circuitry 230 to generate a voltage signal. These voltage and current measurements are used to determine impedance. Alternatively or additionally, various embodiments may measure the current using a Hall sensor and/or a transformer.

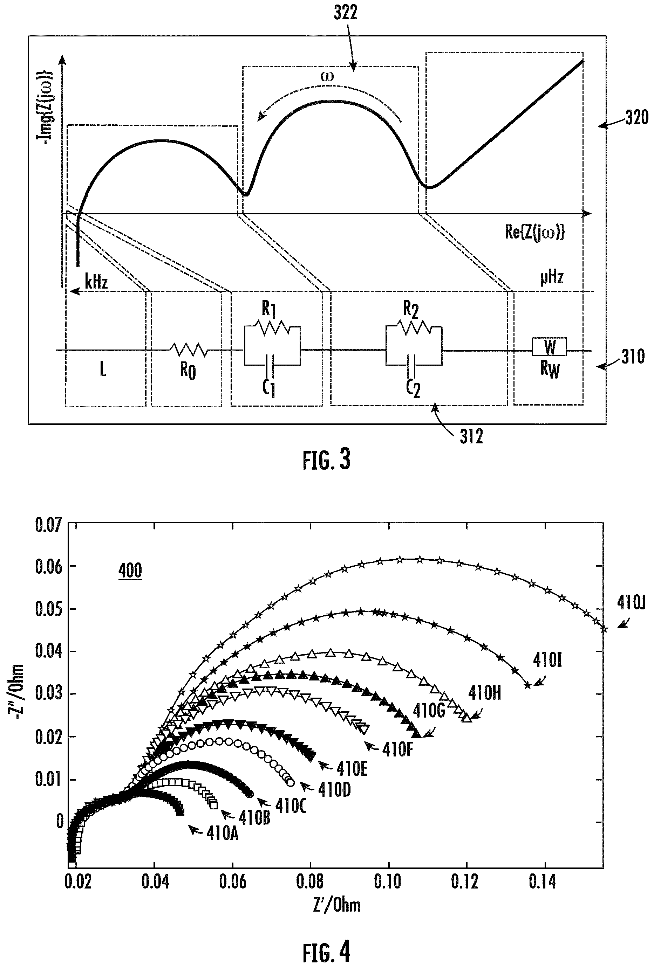

FIG. 3 illustrates an exemplary equivalent circuitry and associated impedance measurements in accordance with one or more embodiments of the present disclosure. Various portions of a battery (e.g., chemical and/or physical portions or aspects) may have different electrical component equivalents. It will be appreciated that FIG. 3 is illustrative and may not be to size and/or various portions of the impedance may be associated with other models that include one or more electrical components. These different electrical component equivalents are associated with the impedance measurements. The exemplary equivalent circuitry 310 associated with the impedance 130 of a battery 100 varies with frequency. For example, and going from a frequency with a longer time period (e.g., kHz) to a frequency with a short time period (e.g., $\mu$Hz), the equivalent circuitry of the impedance may be an inductor (L), a first resistor ($R_o$), a second resistor ($R_1$) in parallel with a first capacitor ($C_1$), a third resistor ($R_2$) in parallel with a second capacitor ($C_2$), and a resistor (Rw), which is referred to in FIG. 3 with reference number 312. For EIS measurements, the values of the impedance of the third resistor ($R_2$) in parallel with the second capacitor ($C_2$), which is referred to as 322, could be used as these values change as a battery ages or is damaged.

The top portion of FIG. 3 is a graph 320 of the positive real portion of an impedance on the x-axis and a negative imaginary portion of the impedance on the y-axis. The y-axis using the negative imaginary portion of the impedance 322 is due to the capacitor in the equivalent model as capacitors have a negative imaginary impedance. The change in the impedance 322 over time may be graphed, which may demonstrate how the impedance 322 changes with age and/or damage.

FIG. 4 illustrates an exemplary graph of impedance measurements in accordance with one or more embodiments of the present disclosure. A graph 400 includes measurements of the impedance, including impedance 322, of a battery 100 over time after different numbers of cycles.

The graph 400 is of a Nyquist diagram that includes 10 impedances as measured for a battery 100 after 10 periods of 100 cycles.

The first impedance 410A is after 100 cycles.

The second impedance 410B is after 200 cycles.

The third impedance 410C is after 300 cycles.

The fourth impedance 410D is after 400 cycles.

The fifth impedance 410E is after 500 cycles.

The sixth impedance 410F is after 600 cycles.

The seventh impedance 410G is after 700 cycles.

The eighth impedance 410H is after 800 cycles.

The ninth impedance 410I is after 900 cycles.

The tenth impedance 410J is after 1000 cycles.

As illustrated in FIG. 4, the aging of a battery 100 through cycling increases the impedance 322 from 100 cycles (e.g., 410A) to 1000 cycles (e.g., 410J). Specifically, the arc of impedance 322, which is the second arc, widens with aging. As illustrated, the impedance is measured at a plurality of frequencies, such as with a frequency sweep. In various embodiments, the frequency sweep may be performed by varying the frequency of the stimulus signal provided to a battery 100. By determining impedance measurements the state of health of the battery may be determined.

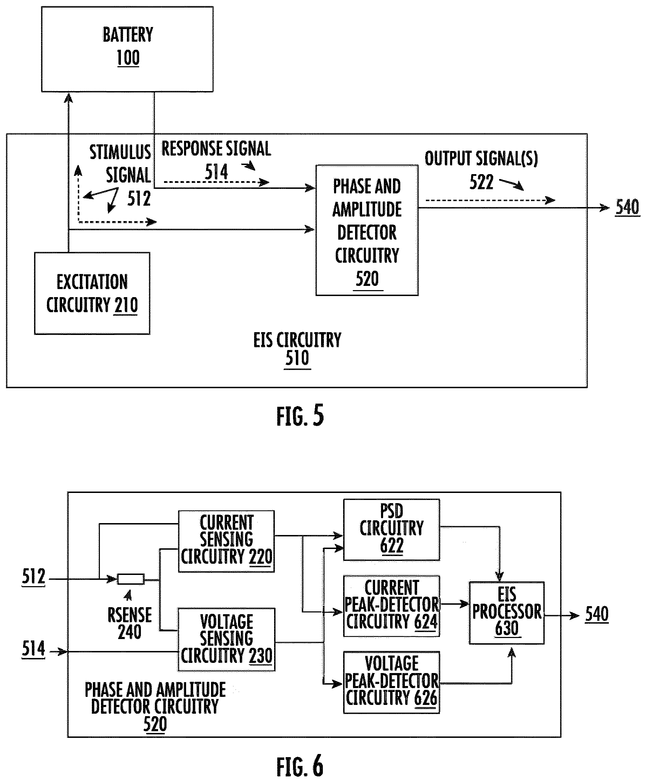

FIG. 5 illustrates a first exemplary block diagram for generating EIS measurements in accordance with one or more embodiments of the present disclosure. FIG. 5 includes a battery 10 and EIS circuitry 510, which may include excitation circuitry 210 and phase and amplitude detector circuitry 520. The EIS circuitry 510 generates a stimulus signal and analyzes a response signal 514 along with the stimulus signal 512 to generate one or more output signal(s) 522. The excitation circuitry 210 may generate a stimulus signal 512 (a.k.a. excitation signal) that may be provided to a battery 100 as well as to the phase and amplitude detector circuitry 520. The stimulus signal 512 may result in the battery 100 generating a response signal 514 that is provided to and received by the EIS circuitry 510. The response signal 514 may be provided to the phase and amplitude detector circuitry 520. The phase and amplitude detector circuitry 520 may generate at least one output signal(s) 522. In various embodiments, the output signal(s) 522 may be provided to an external system, device, apparatus, or application 540, such as a battery management system.

In various embodiments, the output signal(s) 522 may be a single signal or may be multiple signals. For example, the output signal(s) 522 may be a phase output signal associated with the impedance of the battery and generated by the phase and amplitude detector circuitry 520. The output signal(s) 522 may be a phase output signal associated with the impedance of the battery and an amplitude output signal associated with the impedance of the battery, each of which are generated by the phase and amplitude detector circuitry 520. The output phase signal may be a phase of the response signal with respect to the stimulus signal. The output amplitude signal may be the amplitude of the response signal.

In various embodiments, the EIS circuitry 510 may be a part of a battery management system. The battery management system may provide one or more input signals to the excitation circuitry 210 for generating a stimulus signal 512. The stimulus signal 512 generated may be a sinewave, a square wave, a triangle wave, or the like. The frequency of the stimulus signal 512 may vary over time and/or multiple stimulus signals 512 may be generated to vary the frequency.

In various embodiments, the EIS circuitry and/or phase and amplitude detector circuitry 520 may include current sensing circuitry 220, voltage sensing circuitry 230, phase circuitry, current amplitude circuitry, voltage amplitude circuitry, and/or an EIS processor. Alternatively or additionally, the EIS circuitry may include a square wave generator circuitry, PSD circuitry, filter circuitry, and/or an EIS processor. In various embodiments, the phase circuitry may be a PSD circuitry (e.g., 622), a phase detector circuitry (e.g., 722), or a phase lock-in amplifier circuitry (e.g., 822). In various embodiments, the current amplitude circuitry may be current peak-detector circuitry (e.g., 624) or a current lock-in amplifier circuitry (e.g., 824). In various embodiments, the voltage amplitude circuitry may be voltage peak-detector circuitry (e.g., 626) or a voltage lock-in amplifier circuitry (e.g., 826). An EIS processor (e.g., 630, 730, 830, 930, 1030, 1250) may be in the phase and amplitude detector circuitry 520. Alternatively or additionally, the EIS processor may be located elsewhere in the EIS circuitry 510 or outside the EIS circuitry 510. For example, in various embodiments the EIS processor may be a battery management system processor and/or processor of another application or system. In various embodiments, the EIS circuitry and/or phase and amplitude detector circuitry 520 may also include one or more multiplier(s) and/or filter(s). While FIGS. 6-10 and 12 illustrates various embodiments of the phase and amplitude detector circuitry of the EIS circuitry, it will be appreciated that there are additional embodiments not illustrated that are in accord with the description herein.

FIG. 6 illustrates a first exemplary embodiment of phase and amplitude detector circuitry in accordance with one or more embodiments of the present disclosure.

The first exemplary embodiment of the phase and amplitude detector circuitry 510 may receive the stimulus signal 512 and the response signal 514. A current sensing circuitry 220 may generate and output a current signal based on a current measured across sensing resistor 240. A voltage sensing circuitry 230 may generate and output a voltage signal based on a voltage measured between the stimulus signal 512 and the response signal 514. The current signal generated by the current sensing circuitry 220 may be output and provided to a phase sensitive detector (PSD) circuitry 622 and a current peak-detector circuitry 624. The voltage signal generated by the voltage sensing circuitry 230 may be output and provided to the PSD circuitry 622 and a voltage peak-detector circuitry 626. In various embodiments the current sensing circuitry 220 may be a current sensor that generates an output signal-the current signal, and this output signal may be a voltage and/or current that varies with and/or is proportional to the current measured. In various embodiments the voltage sensing circuitry 230 may be a voltage sensor that generates an output signal-the voltage signal, and this output signal may be a voltage and/or current that varies with and/or is proportional to the voltage measured.

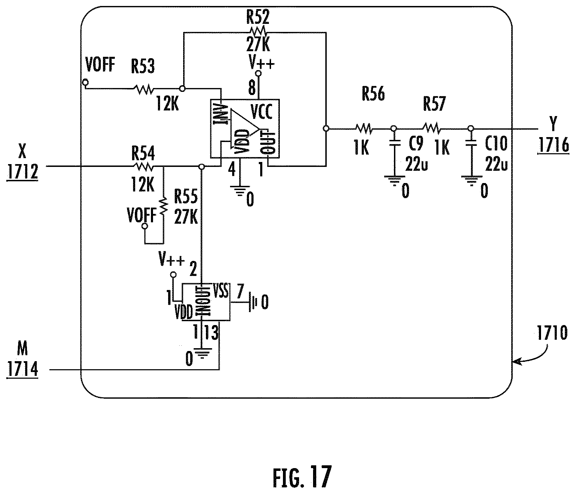

In various embodiments the PSD circuitry 622 comprise analog circuitry of a phase detector circuit, including multiple resistors, an operational amplifier, switches, and capacitors. The operational amplifier may use positive feedback and a switch may control the grounding of the reference signal m. The PSD circuitry 622 may generate an output y based on a first input signal x (e.g., a current signal) and a second input signal m (e.g., a voltage signal). The output y may be represented mathematically as $y(t) = \frac{XM}{\pi} \cos \Delta\Phi$, where X is the amplitude of input signal X, M is the amplitude of the reference signal m, and $\Delta\Phi$ is the difference in phase between the phase of the input signal x and the reference signal m. As illustrated in FIG. 6, the output of the current sensing circuitry 220 and the voltage sensing circuitry 230 are input into the PSD circuitry 622 to measure a shift in phase between the current signal and the voltage signal. An exemplary embodiment of PSD circuitry 622 is illustrated in FIG. 17. In various embodiments, an offset removal filter(s) may be before the PSD circuitry 622.

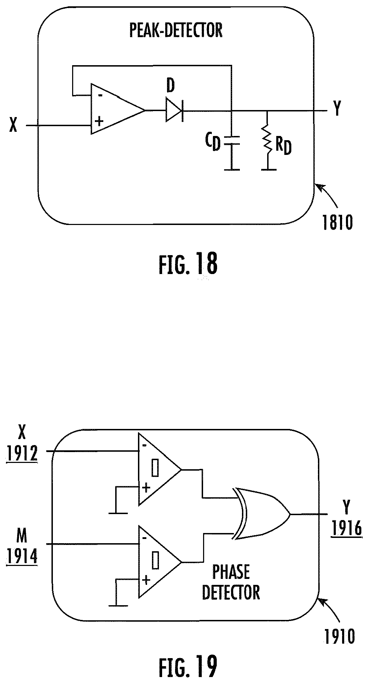

The current peak-detector circuitry 624 may be comprised of analog circuitry that may detect a peak of the current signal. This peak of the current signal may be the amplitude of the current signal. The output y of the current peak-detector circuitry 624 may be represented mathematically as *y(t) = I.* In various embodiments this may be referred to as a current amplitude signal. An exemplary embodiment of peak-detector circuitry, such as current peak-detector circuitry 624, is illustrated in FIG. 18.

The voltage peak-detector circuitry 626 may be comprised of analog circuitry that may detect a peak of the voltage signal. This peak of the voltage signal may be amplitude of the voltage signal. The output y of the current peak-detector circuitry 624 may be represented mathematically as y(t) = V. In various embodiments this may be referred to as a voltage amplitude signal.

The EIS processor 630 may receive the output of the PSD circuitry 622, the output of the current peak-detector circuitry 624, and the output of the voltage peak-detector circuitry 626. Based on these inputs, the EIS processor may determine an output of a phase of cos $\Delta\Phi$ by using division operations. Thus the EIS processor may be configured to perform at least division operations. Such operations to determine a phase measurement of an impedance is an improvement due to the lowering of computational resources as well as time required.

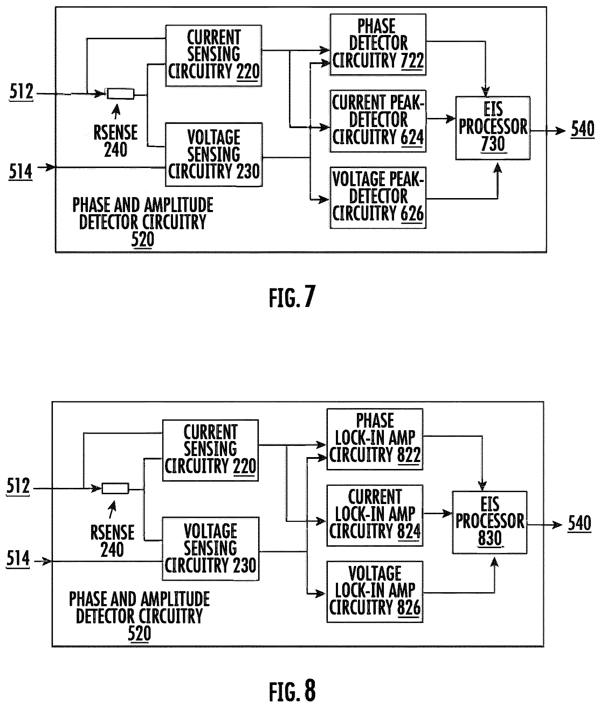

FIG. 7 illustrates a second exemplary embodiment of phase and amplitude detector circuitry in accordance with one or more embodiments of the present disclosure. The second exemplary embodiment of phase and amplitude detector circuitry 520 is similar to that illustrated in FIG. 6 though this embodiment includes phase detector circuitry 722 and EIS processor 730.

The phase detector circuitry 722 may receive the current signal from the current sensing circuitry 220 and the voltage signal from the voltage sensing circuitry 230. In various embodiments, the phase detector circuitry 722 may include multiple op amps and a XOR gate. The output y of the phase detector circuitry may be represented mathematically as y(t) = $\Delta$t. An exemplary embodiment of phase detector circuitry 722 is illustrated in FIG. 19.

The EIS processor 730 may receive the output of the phase detector circuitry 722, the output of the current peak-detector circuitry 624, and the output of the voltage peak-detector circuitry 626. Based on these inputs, the EIS processor 730 may determine an output of an amplitude value and a phase angle by using division operations. For example, EIS processor 730 may generate outputs signals y1 and y2, where $y1 = |Z| = \left|\frac{B}{A}\right|$ and $y2 = \angle Z = 360° \frac{\Delta t}{T_{wave}}$ where Twave is the known frequency of the stimulus signal 512. Thus the EIS processor 730 may be configured to perform at least division operations.

FIG. 8 illustrates a third exemplary embodiment of phase and amplitude detector circuitry in accordance with one or more embodiments of the present disclosure. The third exemplary embodiment of phase and amplitude detector circuitry 520 is similar to that illustrated in FIGS. 6 and 7 though this embodiment includes phase lock-in amp circuitry 822, current lock-in amp circuitry 824, voltage lock-in amp circuitry 824, and EIS processor 830.

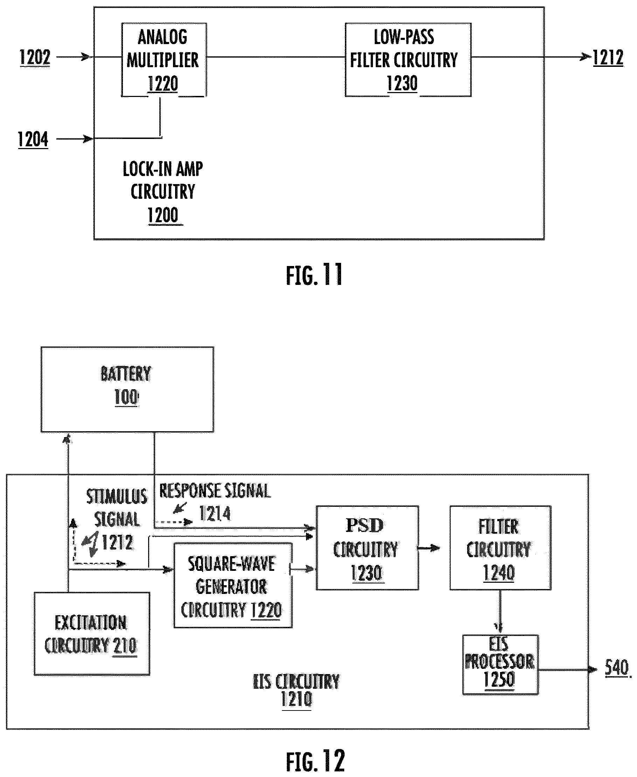

The phase lock-in amp circuitry 822, current lock-in amp circuitry 824, and voltage lock-in amp circuitry 824 each use lock-in amplifiers. An exemplary embodiment of a lock-in amplifier is illustrated in FIG. 12.

The phase lock-in amp circuitry 822 inputs the current signal as a first input and the voltage signal as a second input. The output y of the phase lock-in amp circuitry may be represented mathematically as $y(t) = \frac{IV}{2} \cos \Delta\Phi$.

The current lock-in amp circuitry 824 inputs the current signal to both inputs of the lock-in amplifier. The output y of the current lock-in amp circuitry is the square of the amplitude of the input, which may be represented mathematically as y(t) = $I^2$.

The voltage lock-in amp circuitry 826 inputs the voltage signal to both inputs of the lock-in amplifier. The output y of the voltage lock-in amp circuitry is the square of the amplitude of the input, which may be represented mathematically as y(t) = $V^2$.

The EIS processor 830 may receive the output of the phase lock-in amp circuitry 822, the output of the current lock-in amp circuitry 824, and the output of the voltage lock-in amp circuitry 826. Based on these inputs, the EIS processor 830 may determine an output of a phase of cos $\Delta\Phi$ by using division operations. Thus the outputs of the respective lock-in amplifier circuitry is distinct from that of other emobidments but allows for simiraly determining the cos $\Delta\Phi$ as done in

various other embodiments.

Various embodiments may include both lock-in amplifier circuitry and peak-detector circuitry.

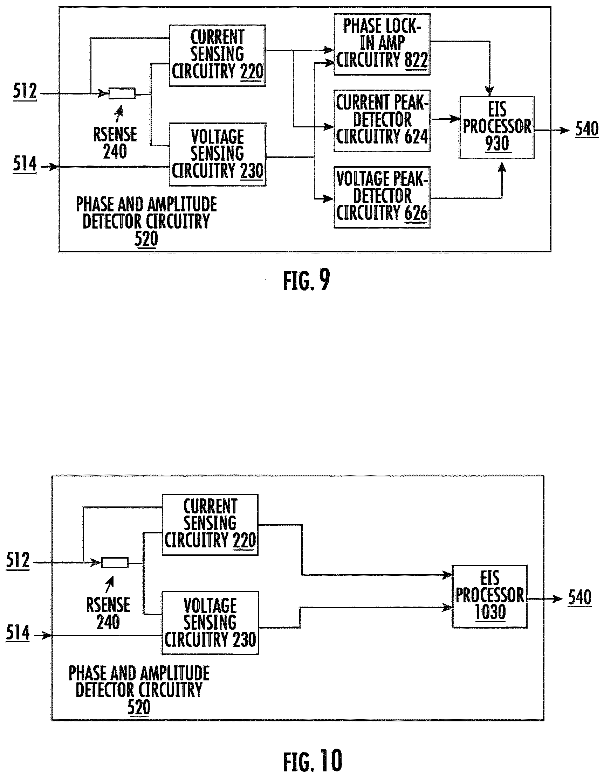

FIG. 9 illustrates a fourth exemplary embodiment of phase and amplitude detector circuitry in accordance with one or more embodiments of the present disclosure. The fourth exemplary embodiment of phase and amplitude detector circuitry 520 is similar to other illustrated embodiments though this fourth exemplary embodiment includes phase lock-in amp circuitry 822, current peak-detector circuitry 624, voltage peak-detector circuitry 626, and EIS processor 930.

The phase lock-in amp circuitry 822, as described herein, generates an output which may be represented mathematically as $y(t) = \frac{IV}{2} cos \, \Delta\Phi$.

The current peak-detector circuitry 624, as described herein, generates an output which may be represented mathematically as $y(t) = I$.

The voltage peak-detector circuitry 626, as described herein, generates an output which may be represented mathematically as $y(t) = V$.

The EIS processor 930 may receive the output of the phase lock-in amp circuitry 822, current peak-detector circuitry 624, voltage peak-detector circuitry 626. Based on these inputs, the EIS processor 930 may determine an output of a phase of $cos \, \Delta\Phi$ by using multiplication and division operations.

FIG. 10 illustrates a fifth exemplary embodiment of phase and amplitude detector circuitry in accordance with one or more embodiments of the present disclosure. In the fifth exemplary embodiment of the phase and amplitude detector circuitry 520, portions of this circuitry are implemented digitally. The current signal and the voltage signal may be provided as inputs to the EIS processor 1030. The EIS processor may be configured to perform one or more operations for multiplication and filtering (e.g., Butterworth filter) to generate output signals of voltage, current, and phase.

FIG. 11 illustrates an exemplary lock-in amplifier circuitry in accordance with one or more embodiments of the present disclosure. The lock-in amplifier circuitry 1200 is comprised of an analog multiplier 1220 and a low-pass filter circuitry 1230. The analog multiplier is a multiplier circuitry that multiplies the input signal 1202 with a reference signal 1204. The product signal of this multiplication will contain, among other things, a higher frequency component at twice the frequency of the stimulus signal 1212 and response signal 1214. The product signal is provided to the low-pass filter circuitry 1230 that allow for low frequencies to pass while higher frequencies are filtered out. In various embodiments the low-pass filter circuitry 1230 is comprised of a resistor and a capacitor. With an input signal of A and a reference signal of B, the lock-in amplifier circuitry 1200 generates an output which may be represented mathematically as $y(t) = \frac{AB}{2} cos \, \Delta\Phi$.

FIG. 12 illustrates second exemplary block diagram for generating EIS measurements in accordance with one or more embodiments of the present disclosure. FIG. 12 illustrates a battery 100 and EIS circuitry 1210 configured for generating impedance measurements. The EIS circuitry 1210 includes excitation circuitry 210 to generate a stimulus signal 1212. The stimulus signal 1212 is transmitted to the battery 100 and a response signal is received from the battery 100 based on the stimulus signal 100.

The stimulus signal 1212 is also transmitted to a square-wave generator circuitry 1220. square-wave generator circuitry 1220 generates a square wave signal of multiple square waves based on the stimulus signal. In various embodiments, the square-wave generator circuitry 1220 generates three square-waves: the first square waves has an offset of 0 degrees, the second square wave has an offset of 90 degrees, and the third square wave has an offset of 180 degrees. The square wave signal is transmitted to the PSD circuitry 1230. In various embodiments, the excitation circuitry 210 and the square-wave generator circuitry 1220 may be driven or controlled by one or more processors no illustrated, such as by a battery management system processor that may provide, among other things, a clock signal and/or instruction to start and/or end one or more operations.

The PSD circuitry 1230 receives the stimulus signal 1212, the response signal 1214, and/or the square wave signal. The PSD circuitry 1230 compares two or more of these signals to generate one or more output signals.

In various embodiments, the PSD circuitry 1230 may determine an amplitude of a voltage and a current, which may depend on the input signal evaluated. An impedance modulus and phase may be determined as a ratio of the voltage to current (i.e., V/I) and $\Delta\varphi$, respectively. The output of the PSD circuitry 1230 may be similar to what is described herein for PSD circuitry 622.

In various embodiments, the stimulus signal 1212 may be sinusoidal, such as a cosine. The PSD circuitry 1230 may, based on the response signal 214 and three square waves of the square wave signal, generate three output signals, each of which will be proportional with the amplitude and the cosine of the phase of the response signal 214 plus an offset of 0 degrees, 90 degrees, or 180 degrees. These output signals, which may also be referred to as compared signal(s), contain an offset due to an initial offset of the response of the battery. These three output signals may be mathematical characterized as:

$$y(0°) = A \cos(\varphi + 0°) + \text{offset} = A \cos(\varphi) + \text{offset}$$

$$y(90°) = A \cos(\varphi + 90°) + \text{offset} = A \sin(\varphi) + \text{offset}$$

$$y(180°) = A \cos(\varphi+180°) + \text{offset} = -A \cos(\varphi) + \text{offset}$$

The offset may be determined by an addition operation:

$$\text{Offset} = (y(0°) + y(180°))/2 = (A \cos(\varphi) + \text{offset} - A \cos(\varphi) + \text{offset})/2 = (\text{offset} + \text{offset}) / 2$$

The offset may be removed with the filtering circuitry 1240, which may include one or more filters. The filtered output signals may be mathematical characterized as:

$$y(0°) = A \cos(\varphi + 0°) = A \cos(\varphi)$$

$$y(90°) = A \cos(\varphi + 90°) = A \sin(\varphi)$$

$$y(180°) = A \cos(\varphi+180°) = -A \cos(\varphi)$$

The three filtered output signals are provided to the EIS processor 1250, which may perform one or more simple addition, division, or arctangent functions to determine a phase and amplitude of the impedance. By dividing the first filtered output wave y(0°) and the second filtered output wave y(90°) the phase may be determined. For example, such a division removes the amplitude from the signal and an arctangent function allows for determining the phase angle. This may be mathematically characterized as:

$$\varphi = \text{atan}(\ y(90°) / y(0°)) = \text{atan}(\ A\sin(\varphi) / A \cos(\varphi))$$

Determining the amplitude may be done with a division operation by dividing the y(0°) signal by the cosine of the angle.

$$A = A \cos(\varphi)/\cos(\varphi)$$

Thus the phase and amplitude of the impedance from a response signal 214 may be determined. While FIG. 12 illustrates filter circuitry 1240, which may be analog circuitry, in various embodiments the filtering may be performed digitally by the EIS processor 1250.

The various embodiments of the EIS processor (e.g., 1250) allow for a simple processing of signals using simple division operations, multiplication operations, addition operations, low-pass filter operations and the like that result in faster processing with lower computational resources.

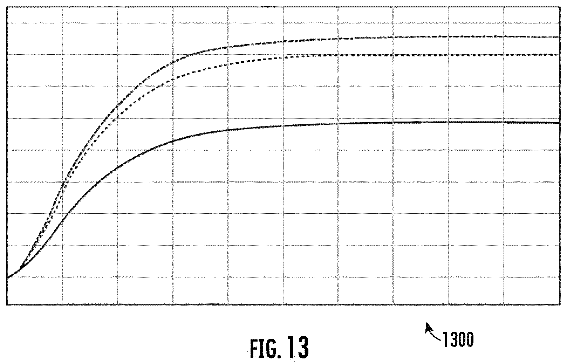

FIG. 13 illustrates an exemplary graph of filtered output signals in accordance with one or more embodiments of the present disclosure. The graph 1300 is of the filtered offset signals and is after the offsets of each of the three filtered offset signals have been removed. This allows only the signals at the lower frequency to pass. As illustrated, the filtered offset signals reach a steady state value. In various embodiments, this steady state value may be reached in, for example, 6 cycles. Such a quick steady state may, in various embodiments, lower computational requirements of any associated analog-to-digital converters associated with the EIS measurements.

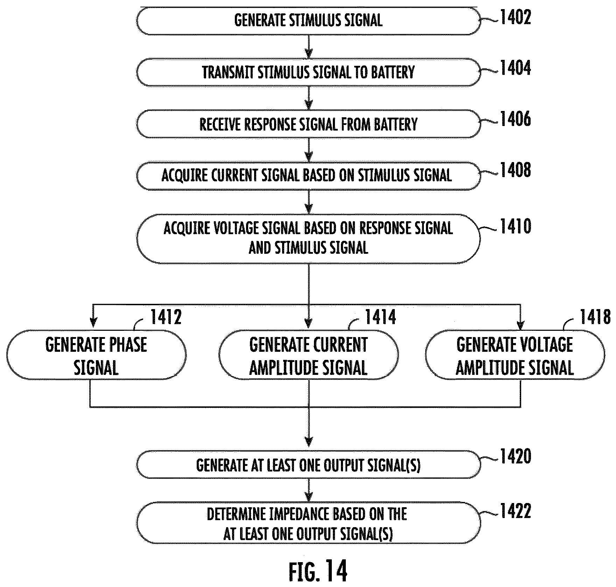

FIG. 14 illustrates an exemplary flowchart of a first set of operations for generating an impedance in accordance with one or more embodiments of the present disclosure. In various embodiments the operations of FIG. 14 may be associated with generating an impedance using an embodiment of the EIS circuitry 510, such as illustrated in at least FIG. 5.

At operation 1402, generate a stimulus signal. The stimulus signal may be generated with excitation circuitry 210 as described herein.

At operation 1404, transmit the stimulus signal to a battery. The excitation circuitry 210 of the EIS circuitry (e.g., 510) may transmit the stimulus signal to a battery 100. In various embodiments, the stimulus signal may also be transmitted to phase and amplitude detector circuitry 520.

At operation 1406, receive response signal from the battery. A response signal 214 is received by the EIS circuitry (e.g., 510) from the battery 100. The response signal 514 is in response to the stimulus signal 512 provided to the battery 100.

At operation 1408, acquire current signal based on the response signal. A current sensing circuitry 220 of the EIS circuitry 510 may acquire a current signal based on the response signal 214. The current signal is based on the current of the response signal 214 measured across a sensing resistor 240, which may acquire a current signal that is proportional to the current measured.

At operation 1410, acquirevoltage signal based on the response signal and the stimulus signal. A voltage sensing circuitry 230 of the EIS circuitry 510 may acquirea voltage signal based on the response signal 514 and the stimulus signal 514. The voltage signal is based on the voltage measured between these two signals, which may acquirea voltage signal that is proportional to the voltage measured.

At operation 1412, generate a phase signal. A phase circuitry may generate a phase signal based on the current signal and the voltage signal. In various embodiments, the phase circuitry may be a PSD circuitry (e.g., 622), a phase detector circuitry (e.g., 722), or a phase lock-in amplifier circuitry (e.g., 822).

At operation 1414, generate a current amplitude signal. A current amplitude circuitry may generate a current amplitude signal based on the current signal. In various embodiments, the current amplitude circuitry may be current peak-detector circuitry (e.g., 624) or a current lock-in amplifier circuitry (e.g., 824).

At operation 1416, generate a voltage amplitude signal. A voltage amplitude circuitry may generate a voltage amplitude signal based on the voltage signal. In various embodiments, the voltage amplitude circuitry may be voltage peak-detector circuitry (e.g., 626) or a voltage lock-in amplifier circuitry (e.g., 826).

At operation 1418, generate at least one output signal(s). The phase signal, current amplitude signal, and voltage signal are provided to an EIS processor. The EIS processor may generate at least one output signal(s) based on the phase signal, current amplitude signal, and voltage signal. The EIS processor may be configured to perform one or more operations, such as division operations, multiplication operations, addition operations, low-pass filter operations and the like to generate one or more output signals. In various embodiments, such output signals may be signals that are proportional to a phase, amplitude, and/or amplitude and phase of an impedance.

At operation 1420, determine impedance based on the at least one output signal(s). The at least one output signal(s) may be provided to a battery management system that may determine an impedance based on the at least one output signals. In various embodiments, the at least one output signals are proportional to the phase, amplitude, and/or amplitude and phase of an impedance. The battery management system may use a look-up table to determine an impedance value associated with the at least one output signal. In various embodiments, multiple output signals are generated via multiple stimulus signals, including from stimulus signals at varying frequencies. For example, one or more stimulus signals may perform a frequency sweep for stimulated the battery 100. These multiple impedances may be used to determine how a battery is aging, such as illustrated in FIG. 4.

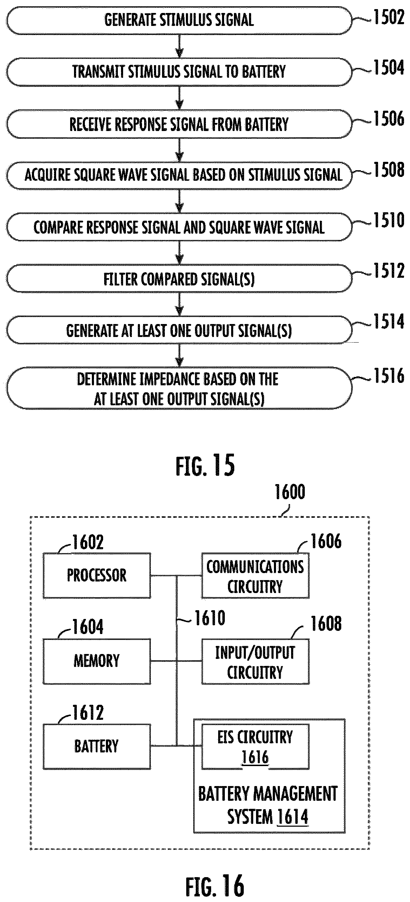

FIG. 15 illustrates an exemplary flowchart of a second set of operations for generating an impedance in accordance with one or more embodiments of the present disclosure. In various embodiments the operations of FIG. 15 may be associated with generating an impedance using an embodiment of the EIS circuitry 1210, such as illustrated in at least FIG. 12.

At operation 1502, generate a stimulus signal. This operation is similar to operation 1402 described herein.

At operation 1504, transmit the stimulus signal to a battery. This operation is similar to operation 1404 described herein.

At operation 1506, receive response signal from the battery. A response signal 214 is received by the EIS circuitry (e.g., 1210) from the battery 100. The response signal 214 is in response to the stimulus signal 1212 provided to the battery 100.

At operation 1508, acquiresquare wave signal(s) based on the stimulus signal. A square wave signal comprised of multiple square waves is generated by square-wave generator circuitry 1220. The square wave signal may be based on the stimulus signal 1212 with three sets of square waves, each at a different phase. These different phases may be 0 degrees, 90 degrees, and 180 degrees.

At operation 1510, compare response signal and square wave signal. A PSD circuitry 1230 may compare the response signal 214 and the square wave signal to generate a compared signal. The compared signal may include an offset as described herein.

At operation 1512, filter compared signal(s). Filter circuitry 1240 may filter the compared signal(s), such as with a low-pass filter. Filtering the compared signals may remove the offset. The filtered signals may be provided to an EIS processor.

At operation 1514, generate at least one output signal(s). An EIS processor may generate at least one output signal as described herein.

At operation 1516, determine impedance based on the at least one output signal(s). This operation is similar to operation 1420 described herein.

EP 4 647 786 A1

FIG. 16 illustrates an exemplary device in accordance with one or more embodiments of the present disclosure. The device 1600 may be a device for an application and/or a system. For example, the device 1600 may be a power tool, electric vehicle, consumer electronics, or the like. The device 1600 illustrated may be a system and/or apparatus that includes a processor 1602, memory 1604, communications circuitry 1606, input/output circuitry 1608, battery 1612, battery management system 1614, EIS circuitry 1616, and all of which may be connected by a bus or buses 1610. While such connections are illustrated as bus 1610, it will be readily appreciated that there may be multiple other connections.

The processor 1602, although illustrated as a single block, may be comprised of a plurality of components and/or processor circuitry. The processor 1602 may be implemented as, for example, various components comprising one or a plurality of microprocessors with accompanying digital signal processors; one or a plurality of processors without accompanying digital signal processors; one or a plurality of coprocessors; one or a plurality of multi-core processors; processing circuits; and various other processing elements. The processor may include integrated circuits. In various embodiments, the processor 1602 may be configured to execute applications, instructions, and/or programs stored in the processor 1602, memory 1604, or otherwise accessible to the processor 1602. When executed by the processor 1602, these applications, instructions, and/or programs may enable the execution of one or a plurality of the operations and/or functions described herein. Regardless of whether it is configured by hardware, firmware/software methods, or a combination thereof, the processor 1602 may comprise entities capable of executing operations and/or functions according to the embodiments of the present disclosure when correspondingly configured.

The memory 1604 may comprise, for example, a volatile memory, a non-volatile memory, or a certain combination thereof. Although illustrated as a single block, the memory 1604 may comprise a plurality of memory components. In various embodiments, the memory 1604 may comprise, for example, a random access memory, a cache memory, a flash memory, a hard disk, a circuit configured to store information, or a combination thereof. The memory 1604 may be configured to write or store data, information, application programs, instructions, etc. so that the processor 1604 may execute various operations and/or functions according to the embodiments of the present disclosure. For example, in at least some embodiments, a memory 1604 may be configured to buffer or cache data for processing by the processor 1602. Additionally or alternatively, in at least some embodiments, the memory 1604 may be configured to store program instructions for execution by the processor 1602. The memory 1604 may store information in the form of static and/or dynamic information. When the operations and/or functions are executed, the stored information may be stored and/or used by the processor 1602.

The communication circuitry 1606 may be implemented as a circuit, hardware, computer program product, or a combination thereof, which is configured to receive and/or transmit data from/to another component or apparatus. The computer program product may comprise computer-readable program instructions stored on a computer-readable medium (e.g., memory 1604) and executed by a processor 1602. In various embodiments, the communication circuitry 1606 (as with other components discussed herein) may be at least partially implemented as part of the processor 1602 or otherwise controlled by the processor 1602. The communication circuitry 1606 may communicate with the processor 1602, for example, through a bus 1610. Such a bus 1610 may connect to the processor 1602, and it may also connect to one or more other components of the processor 1602. The communication circuitry 1606 may be comprised of, for example, transmitters, receivers, transceivers, network interface cards and/or supporting hardware and/or firmware/software, and may be used for establishing communication with another component(s), apparatus(es), and/or system(s). The communication circuitry 1606 may be configured to receive and/or transmit data that may be stored by, for example, the memory 1604 by using one or more protocols that can be used for communication between components, apparatuses, and/or systems.

The input/output circuitry 1608 may communicate with the processor 1602 to receive instructions input by an operator and/or to provide audible, visual, mechanical, or other outputs to an operator. The input/output circuitry 1608 may comprise supporting devices, such as a keyboard, a mouse, a user interface, a display, a touch screen display, lights (e.g., warning lights), indicators, speakers, and/or other input/output mechanisms. The input/output circuitry 1608 may comprise one or more interfaces to which supporting devices may be connected. In various embodiments, aspects of the input/output circuitry 1608 may be implemented on a device used by the operator to communicate with the processor 1602. The input/output circuitry 1608 may communicate with the memory 1604, the communication circuitry 1606, and/or any other component, for example, through a bus 1610.

A battery 1612 may provide power to the device 1600. In various embodiments, the battery 1612 may be a single battery cell or may be multiple battery cells that form one or more battery packs.

The battery management system 1614 may include EIS circuitry 1616, one or more dedicated processors, one or more dedicated memories, and/or additional electrical components. In various embodiments the EIS circuitry 1616 may be configured as described herein and configured to perform one or more operations as described herein. The EIS circuitry may generate one or more output signals that may be provided to the battery management system 1614 to determine and/or generate an impedance of the battery 1612. In various embodiments, the impedance of the battery 1612 may be determined via a look-up table based on the output signal(s) of the EIS circuitry 1616. This impedance of the battery 1612 may be used by the battery management system 1614 to determine, among other things, a state of health of the battery.

The device 1600 may generate or perform one or more operations based on the state of health of the battery 1612, such as cease battery operations, shut down the device 1600, generate, display, and/or transmit a warning message, and the like.

FIG. 17 illustrates an exemplary phase sensitive detector circuitry in accordance with one or more embodiments of the present disclosure. In various embodiments, the phase sensitive detector (PSD) circuitry 1710 may comprise analog circuitry of a phase detector circuit, including multiple resistors, an operational amplifier, switches, and capacitors. The PSD circuitry may receive as inputs a first signal X 1712 and a second signal M 1714 and generate an output signal Y 1716, such as described herein.

FIG. 18 illustrates an exemplary peak-detector circuitry in accordance with one or more embodiments of the present disclosure. In various embodiments, the peak-detector circuitry 1810 may comprise analog circuitry of an operational amplifier, diode, capacitor(s), and resistor(s). The peak-detector circuitry 1810 may receive as input a first signal X and generate an output signal Y, such as described herein.

FIG. 19 exemplary phase detector circuitry in accordance with one or more embodiments of the present disclosure. In various embodiments, the phase detector circuitry 1910 may be comprised of two flip-flops and a XOR gate. A first signal X 1912 and a second signal M 1914 may be input into the phase detector circuitry 1910, which may generate an output signal Y 1916. The output may be represented mathematically as $y(t) = \Delta t$, such as described herein. The $\Delta t$ represents a period of time proportional to the difference in phase between the two input signals. In various embodiments, the phase detector circuitry 1910 may be a zero-cross detector that indicates when to take the measurement of $\Delta t$ using a flip flop and a XOR gate. The phase detector circuitry 1910 may determine when the signals cross zero and generate a the output of $\Delta t$.

It should be readily appreciated that the embodiments of the systems, apparatuses, and methods described herein may be configured in various additional and alternative manners in addition to those expressly described herein.

Conclusion

Operations and/or functions of the present disclosure have been described herein, such as in flowcharts. As will be appreciated, computer program instructions may be loaded onto a computer or other programmable apparatus (e.g., hardware) to produce a machine, such that the resulting computer or other programmable apparatus implements the operations and/or functions described in the flowchart blocks herein. These computer program instructions may also be stored in a computer-readable memory that may direct a computer, processor, or other programmable apparatus to operate and/or function in a particular manner, such that the instructions stored in the computer-readable memory produce an article of manufacture, the execution of which implements the operations and/or functions described in the flowchart blocks. The computer program instructions may also be loaded onto a computer, processor, or other programmable apparatus to cause a series of operations to be performed on the computer, processor, or other programmable apparatus to produce a computer-implemented process such that the instructions executed on the computer, processor, or other programmable apparatus provide operations for implementing the functions and/or operations specified in the flowchart blocks. The flowchart blocks support combinations of means for performing the specified operations and/or functions and combinations of operations and/or functions for performing the specified operations and/or functions. It will be understood that one or more blocks of the flowcharts, and combinations of blocks in the flowcharts, can be implemented by special purpose hardware-based computer systems which perform the specified operations and/or functions, or combinations of special purpose hardware with computer instructions.

While this specification contains many specific embodiments and implementation details, these should not be construed as limitations on the scope of any disclosures or of what may be claimed, but rather as descriptions of features specific to particular embodiments of particular disclosures. Certain features that are described herein in the context of separate embodiments can also be implemented in combination in a single embodiment. Conversely, various features that are described in the context of a single embodiment can also be implemented in multiple embodiments separately or in any suitable subcombination. Moreover, although features may be described above as acting in certain combinations and even initially claimed as such, one or more features from a claimed combination can in some cases be excised from the combination, and the claimed combination may be directed to a subcombination or variation of a subcombination.

While operations and/or functions are illustrated in the drawings in a particular order, this should not be understood as requiring that such operations and/or functions be performed in the particular order shown or in sequential order, or that all illustrated operations be performed, to achieve desirable results. In certain circumstances, operations and/or functions in alternative ordering may be advantageous. In some cases, the actions recited in the claims may be performed in a different order and still achieve desirable results. Thus, while particular embodiments of the subject matter have been described, other embodiments are within the scope of the following claims.

While this detailed description has set forth some embodiments of the present invention, the appended claims cover other embodiments of the present invention which differ from the described embodiments according to various modifications and improvements.

Within the appended claims, unless the specific term "means for" or "step for" is used within a given claim, it is not intended that the claim be interpreted under 35 U.S.C. § 112, paragraph 6.

**Claims**

1. A system comprising:

- a battery (100);
- a battery management system comprising EIS circuitry (510), wherein the battery management system is electrically coupled to the battery (100);

wherein the EIS circuitry (510) comprising excitation circuitry (210) configured to generate a stimulus signal (512);

wherein the EIS circuitry (510) is configured to provide the stimulus signal (512) to the battery (100) and to receive a response signal from the battery (100) based on the stimulus signal (512);
wherein the EIS circuitry (510) further comprises a current sensing circuitry (220) configured to generate a current signal based on the response signal;
wherein the EIS circuitry (510) further comprises a voltage sensing circuitry (230) configured to generate a voltage signal based on the stimulus signal (512) and the response signal;
wherein the EIS circuitry (510) further comprises a phase circuitry (520) configured to generate a phase signal based on the current signal and the voltage signal;
wherein the EIS circuitry (510) further comprises a current amplitude circuitry (520) configured to generate a current amplitude signal based on the current signal;
wherein the EIS circuitry (510) further comprises a voltage amplitude circuitry (520) configured to generate a voltage amplitude signal based on the voltage signal;
wherein an EIS processor is configured to generate at least one output signal based on the phase signal, the current amplitude signal, and the voltage amplitude signal; and
wherein the battery management system is configured to generate a first impedance based on an EIS model and the at least one output signal.

2. A battery management integrated circuit comprising:

- a battery management processor;
- a EIS circuitry (510) comprising excitation circuitry (210) configured to generate a stimulus (512)signal;

wherein the EIS circuitry (510) is configured to provide the stimulus signal (512) to a battery (100) and to receive a response signal from the battery (100) based on the stimulus signal (512);
wherein the EIS circuitry (510) further comprises a current sensing circuitry (220) configured to generate a current signal based on the response signal;
wherein the EIS circuitry (510) further comprises a voltage sensing circuitry (230) configured to generate a voltage signal based on the stimulus signal (512) and the response signal;
wherein the EIS circuitry (510) further comprises a phase circuitry (520) configured to generate a phase signal based on the current signal and the voltage signal;
wherein the EIS circuitry (510) further comprises a current amplitude circuitry (520) configured to generate a current amplitude signal based on the current signal;
wherein the EIS circuitry (510) further comprises a voltage amplitude circuitry (520) configured to generate a voltage amplitude signal based on the voltage signal;
wherein an EIS processor is configured to generate at least one output signal based on the phase signal, the current amplitude signal, and the voltage amplitude signal; and
wherein the battery management processor is configured to generate a first impedance based on an EIS model and the at least one output signal.

3. A method comprising:

- generating, with an excitation circuitry (210), a stimulus signal (512);
- transmitting the stimulus signal (512) to a battery (100) to generate a response signal;
- receiving the response signal at a EIS circuitry (510);
- generating, with the EIS circuitry (510), a current signal based on the response signal;

- generating, with the EIS circuitry (510), a voltage signal based on the response signal and the stimulus signal (512);
- generating, with a phase circuitry (520), a phase signal based on the current signal and the voltage signal;
- generating, with a current amplitude circuitry (520), a current amplitude signal;
- generating, with a voltage amplitude circuitry (520), a voltage amplitude signal;
- generating at least one output signal based on the phase signal, the current amplitude signal, and the voltage amplitude signal; and
- determining a first impedance based on an EIS model and the at least one output signal.

4. The system of claim 1, the circuit of claim 2, or the method of claim 3, wherein the voltage amplitude circuitry (520) comprises a voltage peak-detector (626) and the current amplitude circuitry (520) comprises a current peak-detector (624).

5. The system of claim 1 or 4, the circuit of claim 2 or 4, or the method of claim 3 or 4, wherein the voltage amplitude circuitry (520) comprises a voltage lock-in amplifier (826) and the current amplitude circuitry (520) comprises a current lock-in amplifier (824).

6. The system, the circuit or the method of claim 4 or 5, wherein the phase circuitry (520) comprises one of a phase shift detector (622), a phase detector (722), or a lock-in amplifier (822).

7. The system of any of claims 1, 4 to 6, the circuit of any of claims 2, 4 to 6, or the method of any of claims 3 to 6, wherein the at least one output signal comprises a first output signal of an output phase and a second output signal of an output amplitude.

8. The system of any of claims 1, 4 to 7, the circuit of any of claims 2, 4 to 7, wherein to generate a first impedance based on an EIS model and the at least one output signal the battery management system or the battery management processor is configured to determine the first impedance from a look-up table.

**FIG. 1**

**FIG. 2**

FIG. 3

FIG. 4

**FIG. 5**

**FIG. 6**

512 → RSENSE 240

CURRENT SENSING CIRCUITRY 220

514 →

VOLTAGE SENSING CIRCUITRY 230

PHASE AND AMPLITUDE DETECTOR CIRCUITRY 520

PHASE DETECTOR CIRCUITRY 722

CURRENT PEAK-DETECTOR CIRCUITRY 624

VOLTAGE PEAK-DETECTOR CIRCUITRY 626

EIS PROCESSOR 730 → 540

FIG. 7

512 → RSENSE 240

CURRENT SENSING CIRCUITRY 220

514 →

VOLTAGE SENSING CIRCUITRY 230

PHASE AND AMPLITUDE DETECTOR CIRCUITRY 520

PHASE LOCK-IN AMP CIRCUITRY 822

CURRENT LOCK-IN AMP CIRCUITRY 824

VOLTAGE LOCK-IN AMP CIRCUITRY 826

EIS PROCESSOR 830 → 540

FIG. 8

FIG. 9

FIG. 10

1202 →

| ANALOG MULTIPLIER 1220 |

→ LOW-PASS FILTER CIRCUITRY 1230 → 1212

1204 →

LOCK-IN AMP CIRCUITRY 1200

FIG. 11

| BATTERY 100 |

STIMULUS SIGNAL 1212

RESPONSE SIGNAL 1214

SQUARE-WAVE GENERATOR CIRCUITRY 1220

PSD CIRCUITRY 1230

FILTER CIRCUITRY 1240

EXCITATION CIRCUITRY 210

ETS PROCESSOR 1250 → 540

EIS CIRCUITRY 1210

FIG. 12

21

FIG. 13

↖1300

GENERATE STIMULUS SIGNAL — 1402

TRANSMIT STIMULUS SIGNAL TO BATTERY — 1404

RECEIVE RESPONSE SIGNAL FROM BATTERY — 1406

ACQUIRE CURRENT SIGNAL BASED ON STIMULUS SIGNAL — 1408

ACQUIRE VOLTAGE SIGNAL BASED ON RESPONSE SIGNAL AND STIMULUS SIGNAL — 1410

GENERATE PHASE SIGNAL — 1412

GENERATE CURRENT AMPLITUDE SIGNAL — 1414

GENERATE VOLTAGE AMPLITUDE SIGNAL — 1418

GENERATE AT LEAST ONE OUTPUT SIGNAL(S) — 1420

DETERMINE IMPEDANCE BASED ON THE AT LEAST ONE OUTPUT SIGNAL(S) — 1422

FIG. 14

GENERATE STIMULUS SIGNAL ~1502

TRANSMIT STIMULUS SIGNAL TO BATTERY ~1504

RECEIVE RESPONSE SIGNAL FROM BATTERY ~1506

ACQUIRE SQUARE WAVE SIGNAL BASED ON STIMULUS SIGNAL ~1508

COMPARE RESPONSE SIGNAL AND SQUARE WAVE SIGNAL ~1510

FILTER COMPARED SIGNAL(S) ~1512

GENERATE AT LEAST ONE OUTPUT SIGNAL(S) ~1514

DETERMINE IMPEDANCE BASED ON THE AT LEAST ONE OUTPUT SIGNAL(S) ~1516

FIG. 15

1600

1602 PROCESSOR

1606 COMMUNICATIONS CIRCUITRY

1604 MEMORY

1610

1608 INPUT/OUTPUT CIRCUITRY

1612 BATTERY

EIS CIRCUITRY 1616

BATTERY MANAGEMENT SYSTEM 1614

FIG. 16

FIG. 17

PEAK-DETECTOR

D

X

$C_D$  $R_D$

Y

1810

FIG. 18

X
1912

M
1914

PHASE
DETECTOR

Y
1916

1910

FIG. 19

Europäisches
Patentamt
European
Patent Office
Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2023/130590 A1 (HONG KONG APPLIED SCIENCE & TECH RESEARCH INST CO LTD [CN]) 13 July 2023 (2023-07-13) * paragraph [0023] - paragraph [0089]; figures 1-10 * | 1-8 | INV. G01R31/367 G01R31/3842 G01R31/389 G01R31/392 |
| X | US 2023/314529 A1 (MATSUKAWA KAZUO [JP]) 5 October 2023 (2023-10-05) * paragraph [0021] - paragraph [0125]; figures 1-15 * | 1-3,5 | |
| X | US 2017/219660 A1 (CHRISTENSEN ANDREAS ELKJAER [DK] ET AL) 3 August 2017 (2017-08-03) * paragraph [0004] - paragraph [0136]; figures 1-12 * | 1-3 | |

TECHNICAL FIELDS
SEARCHED      (IPC)

G01R
B60L

The present search report has been drawn up for all claims

| Place of search | Date of completion of the search | Examiner |
|---|---|---|
| Munich | 16 September 2025 | Sedlmaier, Stefan |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 25 17 2222

This annex lists the patent family members relating to the patent documents cited in the above-mentioned European search report.
The members are as contained in the European Patent Office EDP file on
The European Patent Office is in no way liable for these particulars which are merely given for the purpose of information.

16-09-2025

| Patent document cited in search report | | Publication date | Patent family member(s) | | Publication date |
|---|---|---|---|---|---|
| WO 2023130590 | A1 | 13-07-2023 | US | 11644513 B1 | 09-05-2023 |
| | | | WO | 2023130590 A1 | 13-07-2023 |
| US 2023314529 | A1 | 05-10-2023 | JP | 7505392 B2 | 25-06-2024 |
| | | | JP | 2022095276 A | 28-06-2022 |
| | | | US | 2023314529 A1 | 05-10-2023 |
| | | | WO | 2022131297 A1 | 23-06-2022 |
| US 2017219660 | A1 | 03-08-2017 | CN | 107076801 A | 18-08-2017 |
| | | | EP | 3186651 A1 | 05-07-2017 |
| | | | US | 2017219660 A1 | 03-08-2017 |
| | | | WO | 2016012922 A1 | 28-01-2016 |

EPO FORM P0459

For more details about this annex : see Official Journal of the European Patent Office, No. 12/82